# EUROPEAN PATENT APPLICATION

(11) **EP 2 015 116 A2**
(43) Date of publication of application: **14.01.2009**
(21) Application number: 08160331.8
(22) Date of filing: 14.07.2008
(51) Int. Cl.: G02B 6/136

(54) **Silicon structure, in particular including an optical waveguide, and method of manufacturing the same**

(30) Priority: 12.07.2007 JP 2007183516
(71) Applicant: NEC CORPORATION, Minato-ku, Tokyo 108-8001 (JP)
(72) Inventor: Watanabe, Shinya, c/o NEC Corporation, Minato-ku, Tokyo (JP)
(74) Representative: Vossius & Partner

(57) **Abstract**

A method of manufacturing a silicon structure, includes: forming an on-substrate structure on a processed layer to have a continuously changing width on a parallel plane to the processed layer; and gradually removing a target portion of the processed layer on a silicon substrate, which is located directly beneath the on-substrate structure, by isotropic etching. The processed layer may be a surface layer of the silicon substrate, or a sacrifice layer formed on the silicon substrate. The structure is particularly suitable for forming the basis of an optical waveguide.

## Description

The present invention relates to a silicon structure, and more particularly relates to a silicon structure containing an on-substrate structure made of silicon compound on a silicon substrate.

As one of the applications of a silicon structure, there is a planner light-wave circuit (PLC). Among various optical devices used for attaining an optical communication, the device using the planner light-wave circuit can be formed by using a manufacturing process of a semiconductor circuit. Accordingly, the device using the planner light-wave circuit has a feature that is superior in smaller scale, higher function and higher integration of the device.

Usually, an optical waveguide manufactured by using a PLC technique is attained as follows. At first, a lower clad layer is formed on a silicon substrate. In succession, a core film through which light is guided is formed. Here, photo masks designed to attain various functions are used, and a photolithography and a dry etching are carried out to form the core in a desirable layout. After that, depending on a case, a reflow layer in which the core is embedded is formed. Then, an upper clad layer is formed.

The thus-manufactured optical waveguide circuit can have various functions such as AWG (Arrayed Waveguides Grating) for coupling or branching a plurality of wavelengths, VOA (Variable optical Attenuator) for attenuating an input light by a desirable quantity, an optical switch for outputting the input light to a desirable port, and the like, on the basis of the layout of the core. The optical characteristics of the optical waveguide itself are represented by an insertion loss (or a propagation loss) and PDL (Polarization Dependent Loss). Usually, they are preferable to be smaller. Here, the PDL is a phenomenon that the insertion loss of the optical waveguide is different on the basis of the polarization state of the light, and this is represented as a separation amount between an insertion loss in a TE mode and an insertion loss in a TM mode. The double refraction of the optical waveguide greatly contributes to this separation. The double refraction implies that the optical waveguide has a different refractive index, depending on a direction. The main reason why the double refraction is generated lies in the internal stress of the optical waveguide (in other words, the stress for keeping the balance with the stress received from outside).

As mentioned above, the optical waveguide is manufactured by laminating the silicon oxide films serving as the clad and the core on the substrate. At this time, usually, its process requires a heating process at a very high temperature of about 1000 °C. For this reason, when the substrate is made of silicon, a wafer is warped due to the difference in a thermal expansion coefficient between the deposited silicon oxide film and the substrate, and the manufactured optical waveguide suffers from the severe stress from the wafer. This stress involves the PDL. Thus, a technique is used which employe various ideas to reduce the stress or attains the balance so that the directivity is not generated.

As one means among them, a structure is proposed which separates the optical waveguide from the silicon substrate. This is the technique for partially floating in the shape of a bridge the optical waveguide from the silicon substrate and relieving the stress from the substrate and consequently reducing the PDL. Such a technique is assumed to be referred to as a bridge structure.

Hereinafter, a "Thermo-Optic Phase Shifter" will be described which can obtain effects in addition to the PDL reduction effect by this bridge structure.

In the optical waveguide circuit, a method is often employed which uses a TO (Thermo-Optic) effect to add a function. This is a technique that positively uses a physical phenomenon in which the refractive index of the glass material of the optical waveguide circuit is changed with heat. For example, in a Mach-Zehnder interferometer provided with a directivity coupler composed of the optical waveguide circuit, input light is branched into two lights which are propagated by a same length and again coupled. Here, a metal heater is placed on the upper portion of one of waveguides for the branched lights. The heater is supplied with electric power to generate heat which causes a change in the phase of the guided light. Through such design, when the branched lights are coupled, the interference state varies in accordance with a phase difference between the lights guided through the optical waveguides so that the output light intensity can be changed. For example, when the phase difference is assumed to be a half of the wavelength of the light, both of the branched lights cancel off each other when they are coupled. Thus, the output becomes approximately zero. Also, when the phase difference is assumed to be zero or integer times of the wavelength, the input light intensity can be extracted in its original state. Here, a portion in which the phase is changed is referred to as a thermo-optic phase shifter.

Through use of those phenomena, it is possible to use the Mach-Zehnder interferometer as an optical switch. Also, since an optional phase difference can be given, it can be used as an optical attenuator from the continuous phase change.

In order to operate the thus-attained optical device, the electric power is supplied to the heater. Therefore, the consumed power necessary for the operation is desired to be small. Usually, the electric power required to shift the light having the wavelength of 1550 nm, which is used in the optical communication, by a half wavelength is about 400 mW. However, when it is required to control 40 channels, the electric power of about 16 W is required. This electric power is very great. Therefore, typically, the electric power consumption is decreased by various ideas on the optical waveguide circuit.

As a scheme for reducing consumed electric power of the tharzo-optic phase shifter realized in the planner light-wave circuit, an optical waveguide having the following structure is represented. In this structure, grooves are formed to sandwich a portion of the optical waveguide functioning as the phase shifter. The groove is filled with air or vacuumed. However, the heat conductivity of gas is sufficiently smaller than that of the silicon oxide film for the clad. Thus, the heat generated by the heater can be prevented from being transferred into the clad. Therefore, the consumed electric power can be made very small, Such a structure is referred to as a ridge structure. Also, the optical waveguide portion sandwiched between the grooves is merely referred to as a ridge.

Usually, the thermo-optic phase shifter with the ridge structure is attained by the following manufacturing method. After the above-mentioned formation of the optical waveguide, the metal film serving as the heater is formed on the upper clad layer by using a sputtering apparatus or an evaporating apparatus. Then, by using a photolithography and milling apparatus in which a photo mask is used, the heater is formed in a desirable layout. Subsequently, similarly to the step of forming the core, the dry etching apparatus is used to form the grooves at a desirable position. At this time, in such a way that the heater is not broken by the dry etching, the heater is required to be sufficiently protected by a resist.

In the ridge structure, the following methods are typically used in order to improve a thermal efficiency. (1) The lower clad layer of the optical waveguide is formed as thick as possible. Thus, the thermal resistance between the core and the silicon substrate is increased, which suppresses the heat from being transferred into the silicon substrate. (2) The upper clad layer of the optical waveguide is formed as thin as possible. Thus, the thermal resistance between the core and the heater is decreased, which improves the efficiency of the thermo-optic effect. (3) In addition, the glass films on both sides of the optical waveguide are removed, to thereby form the ridge shape. Also, the width of the ridge is made as thin as possible. When the structure of the optical waveguide is ridge-shaped, the heat is mainly transferred from the heater to the silicon substrate through the ridge. Thus, as the width of the ridge is made narrower, the junction area between the ridge and the silicon substrate is made smaller, thereby suppressing the thermal diffusion.

However, because of the following reasons, those methods have the limits, respectively.
(1) When the lower clad layer is made excessively thick, the stress applied to the film becomes strong, which is like to increase the PDL of the optical waveguide. Moreover, as it becomes thicker, the time of the manufacturing step becomes longer. (2) When the upper clad layer is made excessively thin, the light is absorbed by the metal of the heater. Thus, the loss of the optical waveguide is increased. (3) When the ridge width is made excessively narrow, the light feels the roughness of the ridge side wall, and the loss caused by dispersion is increased.

Therefore, in addition to the ridge structure, a method of further decreasing the consumed power is to employ the bridge structure described at the beginning. As mentioned above, in the bridge structure, the optical waveguide is separated from the silicon substrate and floated in the shape of the bridge. In case of the thermal phase shifter already containing the ridge structure, this is attained by separating the ridge from the silicon substrate. Similarly to the fact that the ridge structure suppresses the thermal diffusion into the clad, the bridge structure suppresses the thermal diffusion into the silicon substrate. Thus, the effect of the further great reduction in the electric power consumption is obtained. Also, as mentioned above, the bridge structure has the feature of the PDL loss, due to the release of the stress from the substrate that is generated by the line expansion coefficient difference between the optical waveguide film and the substrate. For this reason, the employment of the bridge structure in the thermo-optic phase shifter provides the two great effects of the smaller consumed power and the lower PDL. Hereinafter, such a structure is again referred to as the bridge structure. Also, the waveguide portion floated in the shape of the bridge is referred to as a bridge.

The bridge structure can be attained by using the technique of a sacrifice layer etching that is well known as an MEMS (Micro Electro Mechanical Systems) technique. This is a method in which as disclosed in a Japanese Patent Application Publication (JP-P2004-37524A), the sacrifice layer is deposited in advance on the substrate, and only this layer is finally isotropically etched. This method is attained by the etching through hydrogen fluoride water in which the silicon substrate is used and PSG (PhosphoSilicate Glass) are used as a sacrifice layer. When the silicon oxide film is doped with phosphor, it has an etching rate that is fast for the hydrogen fluoride water. Thus, only the PSG can be selectively etched.

This method has a merit that the special apparatus is not required. However, a seed film serving as the sacrifice layer must be essentially formed between the lower clad layer and the silicon substrate. The subject of this method lies not only in the mere increase in the film forming step, but also in the silicon oxide films laminated on the sacrifice layer in which the refractive index and softening temperature that are suitable for functioning as the waveguide must be adjusted while the etching selectivity is held high for the sacrifice layer. This implies that the design free in the entire manufacturing process is severely robbed. Also, the silicon oxide film other than the sacrifice layer film is etched more or less by the hydrogen fluoride. Therefore, the design and technique for manufacturing it without any damage as the optical waveguide are required.

In this way, aa a substitution method, there is a method of etching the silicon substrate. In this case, the sacrifice layer is not required, which can attain the bridge structure without any influence on the related art established process for manufacturing the optical waveguide. Such a method is disclosed in "Bridge-Suspended Silica-Waveguide Thermo-optic Phase Shifter and Its Application to Mach-Zehnder Type Optical Switch" by A. Suq1ta et al., Trans. IEICE, Vol. E73(1990) pp. 105-109.

Although disclosed in the non-patent document 1, the etching of the silicon substrate is usually attained such that after the formation of the ridge structure, silicon is exposed to the etching gas or solution. The above paper notes only the fact that the silicon substrate is etched by the dry etching. However, the gas of xenon fluoride can be used to perform the isotropic etching on the silicon substrate.

In conjunction to the foregoing descriptions, Japanese Laid Open Patent Application JP-A-Heisei, 10-506756 discloses the invention related to a resonant micro cavity. The resonant micro cavity has a planner cyclic dielectric waveguide and defects inside the cyclic dielectric waveguide. In the resonant micro cavity, the spatial confinement of emission generated inside the waveguide is strengthened around the defects.

Also, Japanese Patent Application Publication JP-F2001-521180A discloses the invention related to an optical integrated circuit. The optical integrated circuit in Japanese Patent Application Publication JP-P2001-521180A is formed inside a silicon layer and supported on a substrate. Here, a part of the silicon layer is arranged in a concave of the substrate and thermally substantially separated from the substrate, Also, a temperature controller is provided for controlling the temperature of an element provided on the part of the silicon layer or thereon.

Moreover, Japanese Patent Application Publication JP-P2004-29359A discloses the invention related to an optical waveguide structure. In the optical waveguide structure according to Japanese Patent Application Publication JP-P2004-29359A an optical waveguide is embedded in a semiconductor substrate. Also, one feature of this is characterized in that the groove structure containing a beam and a groove is contained around the periphery along the longitudinal direction of the optical waveguide.

Also, Japanese Patent Application Publication JP-P2004-133130A is related to an optical circuit. This optical circuit has a silicon substrate, an optical waveguide layer and a temperature controller. Here, the optical waveguide layer has a core and a clad that are formed on the silicon substrate. A temperature controller is formed on the optical waveguide layer to control the temperature of a part of the core locally and variably. In the optical waveguide layer on both sides between which the formation portion of the temperature controller is sandwiched, the region located through an interval from the core is removed along the longitudinal direction of the core from the optical waveguide layer surface to the silicon substrate surface. The concave whose section is rectangular is formed on the silicon substrate surface portion that includes the entire region facing oppositely to the lower portion of the portion removed from the optical waveguide layer. The surface of the silicon substrate creates a silicon (100) crystal plane. On the concave, the side formed along the longitudinal direction of the core creates a silicon (100) crystal plane that is approximately vertical to the silicon substrate surface. The bottom plane of the concave creates a silicon (100) crystal plane that is approximately parallel to the silicon substrate surface.

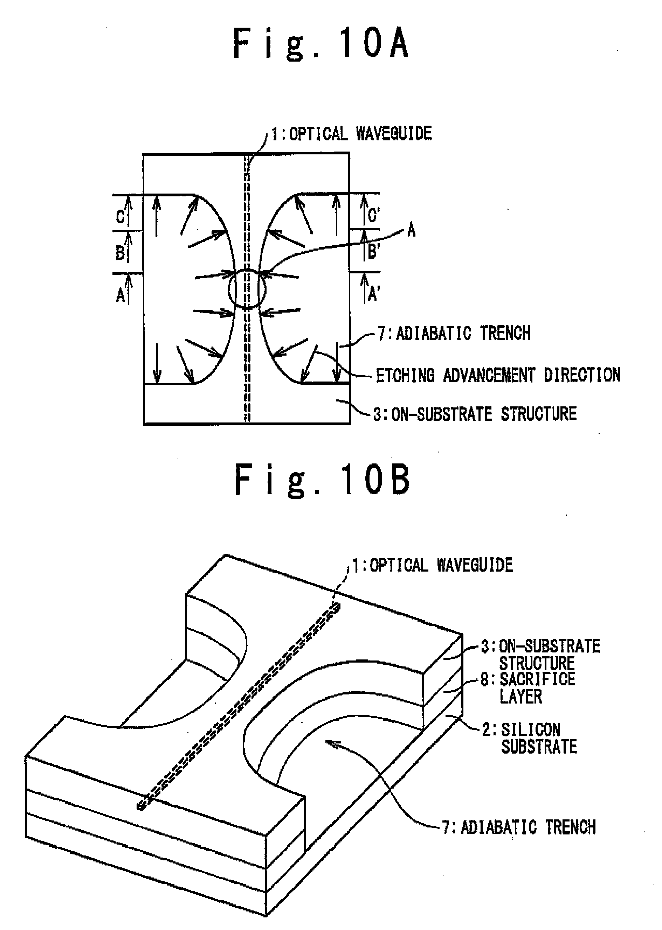

However, there is the severe subject not only in the method of etching the silicon substrate as mentioned above, but also in the bridge structure production through the etching, similarly to the sacrifice layer etching. For example, in the method described in the non-document 1, the silicon substrates immediately under the optical waveguide advance at the same speed from both the directions between which the ridge is sandwiched. When the silicon substrate continues to be etched, as shown in FIG. 10A, the optical waveguide is separated from the silicon substrate, as a result. However, attention should be paid to the fact that the entire length of the optical waveguide is separated instantly at the same time. Usually, the high temperature process between about 800 and 1300 °C is performed on the film of the optical waveguide. Thus, the wafer is largely warped by the thermal stress caused by the thermal expansion coefficient difference between the silicon substrate and the silica film of the optical waveguide. In short, the silica film suffers from the strong stress from the silicon substrate, and both are balanced with each other. Thus, here, when the stress from the silicon substrate is instantly released, there is a case that the bridge is broken.

It should be noted that naturally, the bridge structure from which those subjects are solved is not limited to the optical waveguide circuit, and this can be applied to a different field, instead of the bridge structure through the sacrifice layer etching, for example, to the manufacturing of a cantilever in the MEMS field and the like.

It is therefore an object of the present invention to provide a silicon structure, which is easy in manufacturing, and a method of manufacturing the same.

In an exemplary embodiment of the present invention, a method of manufacturing a silicon structure includes: forming an on-substrate structure on a processed layer to have a continuously changing width on a parallel plane to the processed layer; and gradually removing a target portion of the processed layer on a silicon substrate, which is located directly beneath the on-substrate structure, by isotropic etching. The processed layer may be a surface layer of the silicon substrate, or a sacrifice layer formed on the silicon substrate.

In another exemplary embodiment of the present invention, a silicon structure includes: a processed layer as a part of a silicon substrate or formed on the silicon substrate; and an on-substrate structure formed on the processed layer. The on-substrate structure comprises a silicon compound film. The on-substrate structure includes supporting columns configured to support a target portion of the processed layer directly beneath the on-substrate structure, and the on-substrate structure has a portion that a width continuously changes.

According to the silicon structure with a bridge structure and the method of manufacturing the same, after the width of the bridge structure (or the substrate structure) is continuously changed at the time of designing, the etching process may be performed, thereby making its manufacturing easy. Also, the bridge structure (or the substrate structure) is gradually separated from the silicon substrate. Thus, it is difficult to be damaged at the time of manufacturing.

The above and other objects, advantages and features of the present invention will be more apparent from the following description of certain exemplary embodiments taken in conjunction with the accompanying drawings, in which:
FIGS. 1A and 1B are a plan view and a perspective view showing a method of manufacturing a silicon structure with a bridge structure in accordance with a related art,
FIGS. 2A and 2B are a plan view and a perspective view showing a method of manufacturing a silicon structure with a bridge structure according to a first exemplary embodiment of the present invention;
FIGS. 3A to 3D are sectional views showing the silicon structure according to the first exemplary embodiment of the present invention;
FIG. 4 is a plan view showing another example of the silicon structure according to the first exemplary embodiment;
FIG. 5 is a plan view showing still another example of the silicon structure according to the first exemplary embodiment;
FIG. 6 is a plan view showing the method of manufacturing the silicon structure with the bridge structure according to a second exemplary embodiment of the present invention;
FIG. 7 is a plan view of a Mach-Zehnder interferometer according to a third exemplary embodiment of the present invention;
FIGS. 8A and 8B are a plan view and a perspective view showing a method of manufacturing the silicon structure with the bridge structure according to a fifth exemplary embodiment of the present invention;
FIGS. 9A to 9D are sectional-views showing the silicon structure with the bridge structure according to the fifth exemplary embodiment of the present invention;
FIGS: 10A and 10B are a plan view and a perspective view showing the method of manufacturing the silicon structure with the bridge structure according to a fourth exemplary embodiment; and
FIGS. 11A to 11D are sectional views showing the silicon structure with the bridge structure according to the fourth exemplary embodiment of the present invention.

Hereinafter, a silicon structure according to exemplary embodiments of the present invention will be described with reference to the attached drawings.

Prior to the description of the present invention, the silicon structure in the related art will be described in which a bridge structure is provided.

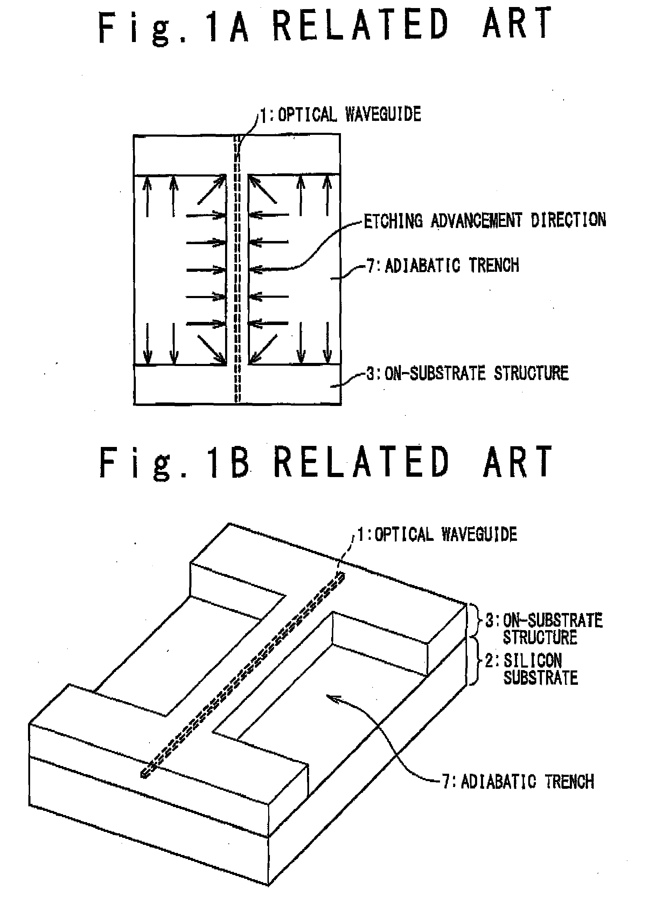

FIGS. 1A and 1B are a plan view and a perspective view showing a method of forming a silicon structure with a bridge structure in the related art, respectively. The silicon structure in the related art has a two-layer structure. A lower layer is a silicon substrate 2, and an upper layer is an on-substrate structure 3. Here, as one example, a case that the on-substrate structure 3 includes the silicon oxide film will be described. It should be noted that an optical waveguide 1 passes through the center of the on-substrate structure, and this silicon structure is used as an optical waveguide circuit.

The optical waveguide 1 is formed from a clad layer and a core, and the core is made from a silicon oxide film into which an element such as phosphor is doped as impurity, namely, a doped silicon oxide film. As the doped silicon oxide film, phosphorous glass is exemplified. The refractive indexes of the core and the clad layer in the optical waveguide 1 are different. Hereinafter, the core and the clad layer around the core in the optical waveguide 1 will be described.

The on-substrate structure 3 is put between trench portions, in which the silicon substrate 2 is exposed. This trench portion in which the silicon oxide film is not formed on the silicon substrate 2 is referred to as an adiabatic trench 7. This trench portion is formed in order to improve a thermal efficiency through the adiabatic effect, when a heater is placed on the optical waveguide 1.

At first, the optical waveguide 1 as a part of the on-substrate structure is formed on the silicon substrate 1. The silicon oxide film 3 is formed on the silicon substrate 2. This layer is later used as a lower clad layer. Subsequently, the core 1 is formed in the shape of a line on the lower clad layer. The shape of the core 1 itself becomes the shape of the optical waveguide 1. The line drawn by the core 1 belongs to a plane parallel to the surface of the silicon substrate 1. However, it may be a straight line or a curved line. It should be noted that as mentioned above, the core 1 is made of the silicon oxide film whose refractive index differs from that of the lower clad layer. Finally, the silicon oxide film is formed on the lower clad layer and the core 1. This layer is used as an upper clad layer. As a result, the core 1 is surrounded by the lower clad layer and the upper clad layer. The entire side of the core 1 is in contact with the lower clad layer or the upper clad layer. Thus, the on-substrate structure can be function as the optical waveguide.

Here, the adiabatic trenches 7 are formed on both sides of the optical waveguide in the on-substrate structure 3. For this purpose, a first etching process is used, such that the silicon substrate 2 is not removed as much as possible, although the silicon oxide film is removed. At this time, the shape of the on-substrate structure which remains after the adiabatic trench 7 is formed through the etching, is required to include the core 1. In this case, the etched on-substrate structure 3 is desired to exhibit the shape along a line drawn by the core 1, or a predetermined line belonging to the plane parallel to the surface of the silicon substrate 2.

After the removal of parts corresponding to the adiabatic trenches 7 is completed such that the on-suhstrate structure 3 is in the designed shape, a second etching is then carried out on the silicon substrate 2. This second etching is desired to remove the silicon substrate 2 and-not to remove the silicon oxide film as much as possible, oppositely to the first etching. Also, in order to remove a portion of the silicon substrate 2 directly beneath the on-substrate structure 3, the second etching is desired to be the isotropic etching.

When the etching process is performed on the silicon structure shown in FIGS. 1A and 1B, the silicon substrate 2 is gradually removed. At this time, the on-substrate structure 3 made of the silicon oxide film does not substantially receive the influence of the etching. Thus, at the start when the etching process is started, only the surface exposed in the adiabatic trench 7 is removed in the silicon substrate 2. At the next moment, the portion directly beneath the on-substrata structure 3 begins to be removed from the side thereof. In this way, the etching is advanced from the upper portion of the adiabatic trench 7 to the lower portion thereof. In the portion directly beneath the on-substrate structure 3, the etching is advanced into the arrow direction of FIG. 1A from the side of the on-substrate structure 3.

A space is formed after the removal of the silicon substrate 2 portion directly beneath the on-substrate structure 3 to connect the trenches 7 on the right and left sides. Thus, the on-substrate structure 3 is separated from the silicon substrate 2 in its portion. In this way, the on-substrate structure 3 can have the bridge structure to float on the silicon substrate 2. At this time, in the portion of the silicon substrate 2 directly beneath the on-substrate structure 3, the etching advances from the both sides of the waveguide 1 at a same rate in the entire region. Thus, recess sections are formed at the same moment in the substrate 2 portion directly beneath the on-substrate structure 3. That is, a part of the on-substrate structure 3 sandwiched by the trenches 7 is instantly separated from the silicon substrate 2. At this time, there is a case that damage is caused in the on-substrate structure 3 due to a stress applied on the on-substrate structure 3.

### [First Exemplary Embodiment]

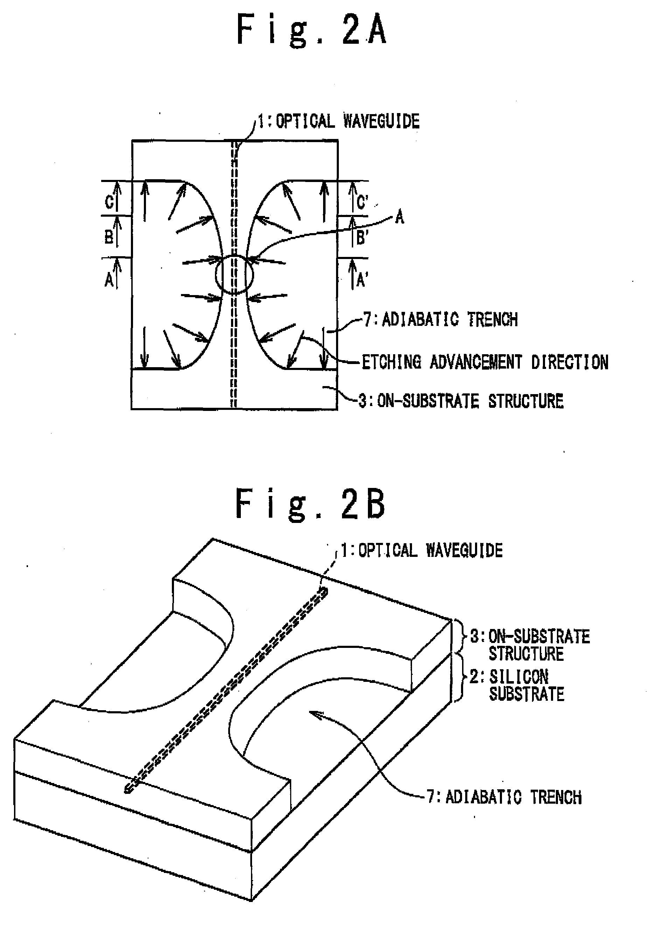

FIGS 2A and 2B are a plan view and a perspective view, which show a method of manufacturing the silicon structure with the bridge structure according to a first exemplary embodiment of the present invention. The difference from the related art shown in FIG. 1A and 1B lies mainly in the shape of the on-substrate structure 3. Specifically, the width of the on-substrate structure 3 is formed to be continuously changed. The condition related to the shape of the on-substrate structure 3 is desired to be determined when the silicon structure is entirely designed.

When the silicon structure in the first exemplary embodiment receives an etching process, the etching advances in the arrow direction of FIG. 2A in a portion of the silicon substrate 2 directly beneath the on-substrate structure 3. In FIG. 2A, in the on-substrate structure 3, an A-portion having the narrowest width on a parallel plane to the surface of the silicon substrate 2 is firstly bridged. That is, the A-portion firstly appears as a removed portion 6 after the removal of the portion of the substrate 2 directly beneath the on-substrate structure 3. After that, the removed portion 6 grows along the optical waveguide 1.

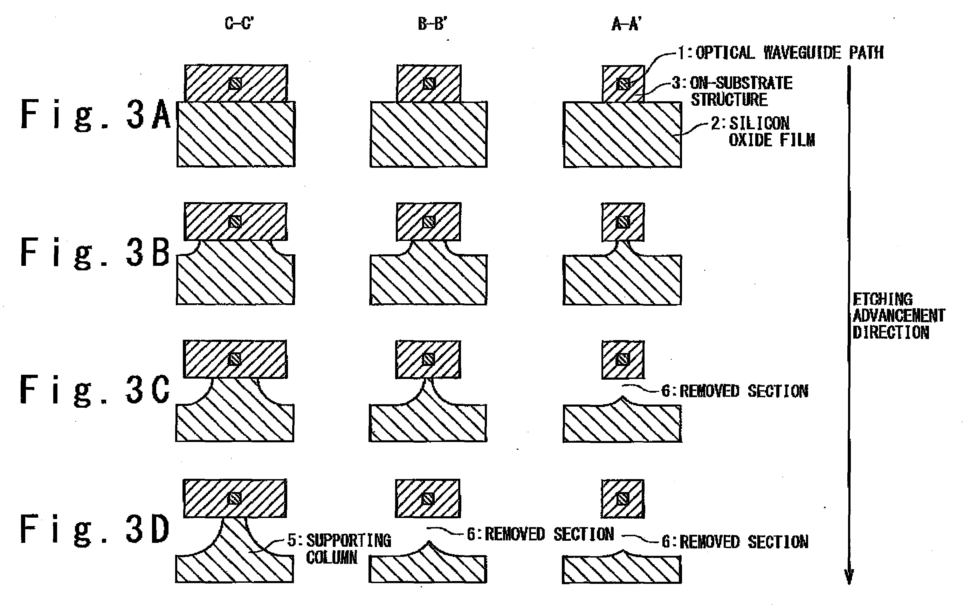

FIGS. 3A to 3D are sectional views showing a method of manufacturing a silicon structure with a bridge structure in accordance with this exemplary embodiment. Left, central and right portions of each of FIGS. 3A to 3D are sectional views of the silicon structure with temporal elapse of an etching process along the.lines C-C', B-B' and A-A' in FIG. 2A, respectively.

The silicon substrate 2, whose surface layer is a processed layer, is gradually removed little by little from the surface in contact with an etchant with advancement of the etching process. At this time, since reaction between the silicon substrate 2 and the etchant is disturbed in the portion where the on-substrate structure 3 exists, the removal of the surface layer of the silicon substrate 2 as the processed layer in the portion directly beneath the on-substrate structure 3 is delayed. However, the silicon substrate 2 portion directly beneath the on-substrate structure 3 is finally removed, thereby generating the space 6 between the on-substrate structure 3 and the silicon substrate 2. This is referred to as the removed section 6. The on-substrate structure 3 immediately over the removed section 6 is separated from the silicon substrate 2 and is realized as the bridge structure.

In particular, as illustrated in the sectional views on the line C-C', as the width of the on-substrate structure 3 becomes wider, the removal of the silicon substrate 2 portion directly beneath it becomes later. Reversely, as illustrated in the sectional views on the line A-A', as the width of the on-substrate structure 3 becomes narrower, the silicon substrate 2 portion directly beneath it becomes earlier. It should be noted that the time of the etching process is adjusted by ending the etching at a predetermined timing, and the size of the removed section 6 after the etching can be adjusted.

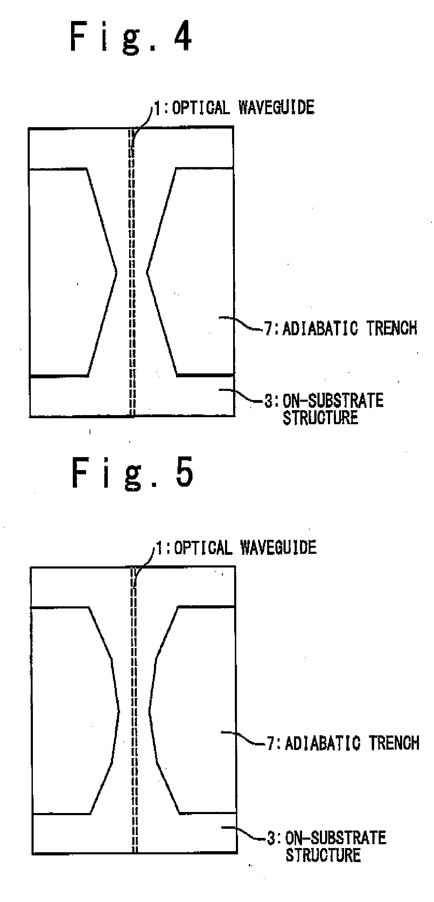

FIGS. 4 and 5 are the plan views showing another example of the shape in which the width of the on-substrate structure 3 in this exemplary embodiment is continuously changed. Even the shape such as a polygonal line is allowable other than the curve shown in FIG. 2A.

### [Second Exemplary Embodiment]

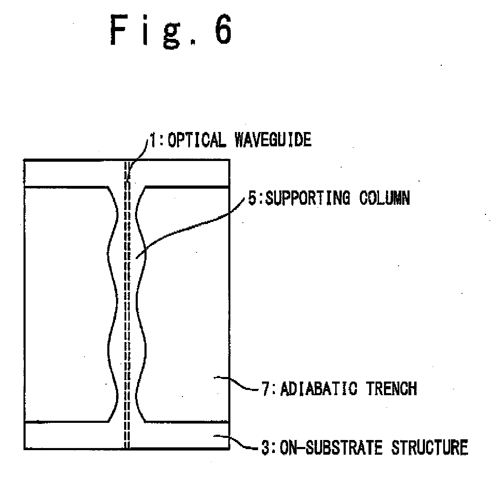

FIG. 6 is a plan view showing the shape of the on-substrate structure 3 according to the second exemplary embodiment of the present invention. The width of the on-substrate structure 3 is continuously changed similarly to the first exemplary embodiment. Moreover, the portion whose width is wide is placed in the middle thereof. The etching process is completed at a predetermined timing so that the silicon substrate 2. portion directly beneath the on-substrate structure 3 can remain after the completion of the etching, as illustrated in the sectional views on the line C-C' in FIGS. 3A to 3D.

As this application, it is possible to provide supporting columns 5 at some portions, even after the on-substrate structure 3 is separated from the silicon substrate 2. In particular, when the on-substrate structure 3 of the bridge structure is relatively elongated, it is supported by the supporting columns 5. Thus, it is possible to attain the effect that the strength of the on-substrate structure 3 is reinforced.

### [Third Exemplary Embodiment]

FIS. 7 is a plan view showing the thermo-optic phase shifter as the silicon structure according to the third exemplary embodiment of the present invention. The thermo-optic phase shifter in this exemplary embodiment contains the two optical waveguide circuits in FIGS. 2A and 2B of the first exemplary embodiment and two heaters 4 formed on the optical waveguide.

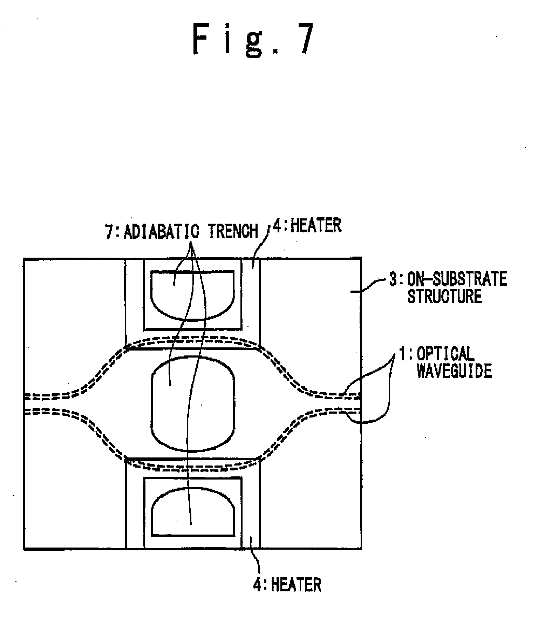

Since the heaters 4 heat the optical waveguides 1, the refractive index of the optical waveguide 1 changes through the thermo-optic effect. By using this phenomenon, the phase difference between the lights passing through the two optical waveguides 1 can be generated. In this way, the thermo-optic phase shifter in FIG. 7 can be used, for example, as the Mach-Zehnder interferometer.

### [Fourth Exemplary Embodiment]

FIGS. 10A and 10B are a plan view and a perspective view, which show a method of manufacturing a silicon structure with a bridge structure, according to the fourth exemplary embodiment of the present invention. The difference from FIGS. 2A and 2B in the first exemplary embodiment lies in only the existence of a sacrifice layer 8 as a processed layer formed on the silicon substrate 2. That is, in the first exemplary embodiment, the surface layer of the silicon substrate 2 as the processed layer is removed by the bridging isotropic etching. However, in this exemplary embodiment, instead of it, a part of the sacrifice layer 8 is removed as the processed layer by the isotropic etching.

Here, in the bridging isotropic etching, only the sacrifice layer 8 is removed, and the silicon substrate 2 and the on-substrate structure 3 are desired not to be removed as much as possible. For this purpose, as one example, the sacrifice layer 8 made of PSG (silica glass to which phosphor is added) is formed on the silicon substrate 2, and the on-substrate structure 3 (silica glass to which boron and phosphor are added) is formed thereon. Moreover, when the wet etching using a BHF (buffered fluorinated acid) solution is used for the bridging isotropic etching, the sacrifice layer 8 can be removed without any deterioration in the on-substrate structure 3.

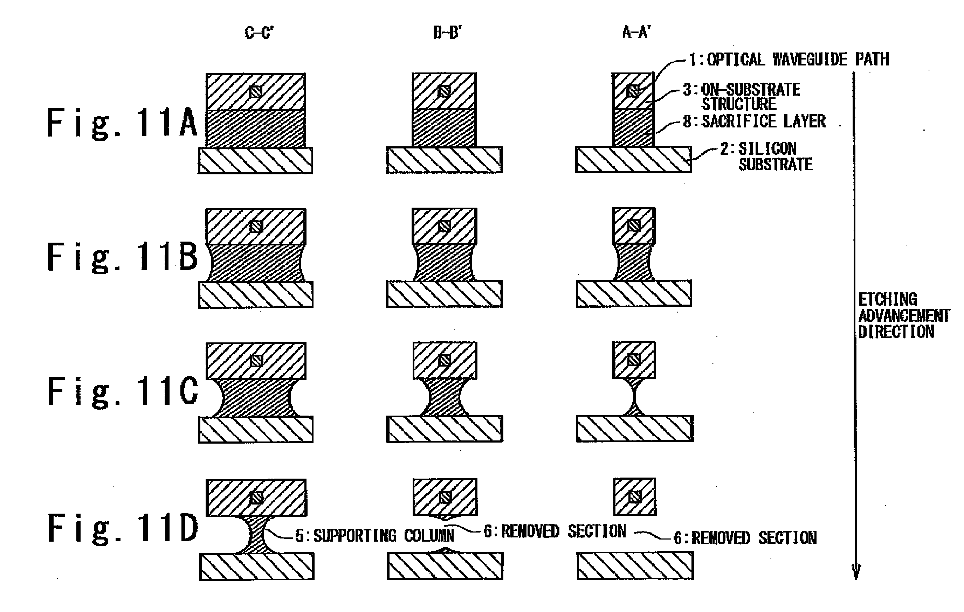

FIGS. 11A to 11D are sectional views showing. the method of manufacturing the silicon structure with the bridge structure, according to this exemplary embodiment. Similarly to FIGS. 3A to 3D in the first exemplary embodiment, the left, the central and the right are sectional views of the silicon structure in the line C-C', th,e line B-B' and the line A-A' in FIGS. 10A to 10D with the temporal elapse of the etching process, respectively.

It should be noted that in this exemplary embodiment, the adiabatic trench 7 is formed by a first etching so that the shape of the on-substrate structure 3 is formed. The sacrifice layer 8 is similarly etched. However, as described later, only the on-substrate structure 3 can be etched depending on the combination of the respective materials of the on-substrate structure 3 and the sacrifice layer 8; and the etchant used in the first etching.

The difference between FIGS. 11A to 11D in this exemplary embodiment and FIGS. 3A to 3D in the first exemplary embodiment lies only in the existence of the sacrifice layer 8. That is, in FIGS. 3A to 3D in the first exemplary embodiment, a part of the silicon substrate 2 is removed by the bridging isotropic etching. However, in FIGS. 11A to 11D in this exemplary embodiment, the sacrifice layer 8 formed between the silicon substrate 2 and the on-substrate structure 3 is removed by the bridging isotropic etching. At this time, as mentioned above, it is important that only the sacrifice layer 8 is selectively etched and the silicon substrate 2 and the on-substrate structure 3 are not removed as much as possible.

Also, the sacrifice layer 8 begins to be removed from the portion in contact with the etchant facing the adiabatic trench 7. As a result, the etching of the sacrifice layer 8 advances from both of the width directions. A portion of the sacrifice layer 8 is removed through the etching from both of the width directions is referred to as the removed section 6. The timing when the removed section 6 is generated is different depending on the initial width of the sacrifice layer 8. For example, in FIG. 11D, the sacrifice layer 8 is perfectly removed in the sectional view along the line A-A'. However, the sacrifice layer 8 still remains in the sectional view along the line C-C'. When the bridging etching is completed at this timing, the remaining sacrifice layer 8 is referred to as the supporting column 5 for supporting the on-substrate structure 3.

Moreover, when the width of the on-substrate structure 3 is designed to be continuously changed, the timing when the on-substrate structure 3 is separated from the silicon substrate 2 is continuously changed. As a result, the separation of the on-substrate structure 3 from the silicon substrate 2 gradually advances. This fact implies that the stress received when the on-substrate structure 3 is changed to have the bridge structure is dispersed and transmitted for a long time. Thus, the effect of the great reduction in the occurrence rate of damage in the on-substrate structure 3 is obtained.

By applying this exemplary embodiment to the second exemplary embodiment, the optical waveguide circuit can be manufactured by a method of using the sacrifice layer etching. Also, when this exemplary embodiment is applied to the third exemplary embodiment, the thermo-optic phase shifter can be manufactured by the method of using the sacrifice layer etching. However, in this case, it is necessary to protect the heater 4 from the etchant by the use of an adequate resist.

### [Fifth Exemplary Embodiment]

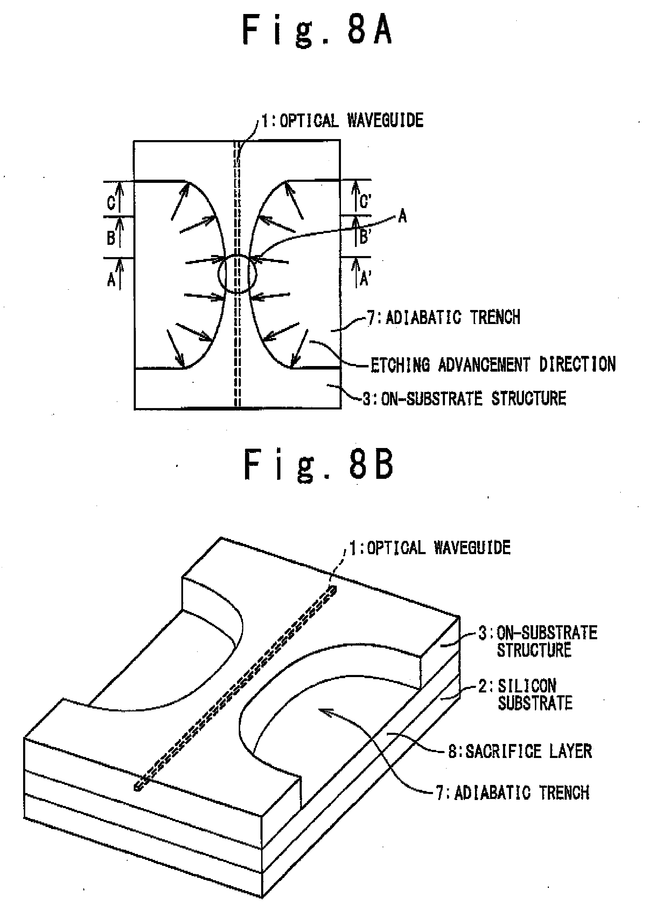

FIGS. 8A and 8B are a plan view and a perspective view, which show a method of manufacturing the silicon structure with the bridge structure according to the fifth exemplary embodiment of the present invention, respectively. Similarly to the fourth exemplary embodiment, the difference between FIGS. 8A and 8B in this exemplary embodiment and FIGS. 2A, 2B in the first exemplary embodiment lies only in the existence of the sacrifice layer 8 formed on the silicon substrate 2. That is, in the first exemplary embodiment, a part of the silicon substrate 2 is removed-by the bridging isotropic etching. However, in this exemplary embodiment, instead of it, a part of the sacrifice layer 8 is removed by the isotropic etching.

Also, the difference between FIBS. 8A and 8B in this exemplary embodiment and FIGS. 10A and 10B in the fourth exemplary embodiment lies in only the shape of the sacrifice layer 8. That is, in the fourth exemplary embodiment, the adiabatic trench 7 is formed on the sacrifice layer 8 and has the shape similar to the on-substrate structure 3. However, in this exemplary embodiment, the adiabatic trench 7 is not formed on the sacrifice layer 8. This is a case that the sacrifice layer 8 is not etched when the adiabatic trench 7 is formed through the first etching so that the shape of the on-substrate structure is formed, as mentioned above.

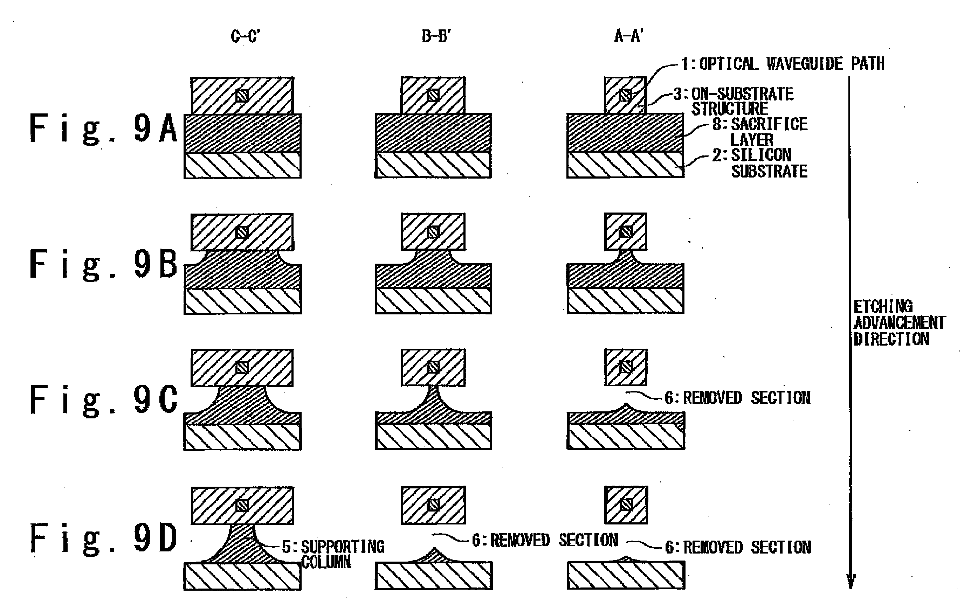

FIGS. 9A to 9D are sectional views showing the method of manufacturing the silicon structure with the bridge structure according to this exemplary embodiment. Similarly to FIBS. 3A to 3D in the first exemplary embodiments the left, center and right are the sectional views of the silicon structure along the line C-C', the line B-B' and the line A-A' in FIG. 8A with the temporal elapse of the etching process, respectively.

The difference between, FIGS. 9A to 9D in this exemplary embodiment and FIGS. 11A to 11D in the fourth exemplary embodiment lies only in the shape of the sacrifice layer B. That is, in FIGS. 11A to 11D in the fourth exemplary embodiment, the etching advanced from both of the right and left sides of the sacrifice layer 8. However, in FIGS. 9A to 9D in this exemplary embodiment, the etching starts from the surface of the sacrifice layer 8 in contact with the etchant. This just resembles FIGS. 3A to 3D in the first exemplary embodiment. The difference between lies in whether the portion directly beneath the on-substrate structure 3 is the sacrifice layer 8 or the silicon substrate 2.

When this exemplary embodiment is applied to the second exemplary embodiment, the optical waveguide circuit can be manufactured by the method of using the sacrifice layer etching. Also, when this exemplary embodiment is applied to the third exemplary embodiment, the thermo-optic phase shifter can be manufactured by the method of using the sacrifice layer etching. However, in this case, the heater 4 is required to be protected from the etchant by the use of an adequate resist.

The attention items common to all of the exemplary embodiments in the present invention will be described below.

At first, when only the thermal efficiency is considered, spreading the width of the on-substrate structure becomes disadvantageous. However, if the suppression of the damage is important when the on-substrate structure is bridged, the present invention is very advantageous.

Until now, the isotropic wet etching in which the liquid etchant is used as the isotropic etching is described as the premise. However, the present invention can be also applied to an isotropic gas etching in which a gas etchant, such as XeF₂ (Xenon 2-Fluoride) is used.

Also, the case has been described that the on-substrate structure is formed as the silicon oxide film. However, if there is no influence on the etching process, any other material is usable. As the specific example, the silicon compound may include silicon oxide, silicon nitride and silicon carbide. In this case, attention should be paid to the selection of etchings of the two kinds used in the present invention.

Moreover, this exemplary embodiment is one application example of the silicon structure of the present invention. The applicable field is not limited to the optical waveguide circuit or the thermo-optic phase shifter. In particular, it can be applied to the MEMS field.

Finally, if the method of manufacturing the silicon structure according to the present invention is again summarized, the silicon compound film is formed directly on the silicon substrate 2 in the first to third exemplary embodiments, and the sacrifice layer 8 is formed directly on the silicon substrate 2 and the silicon compound film is formed on the sacrifice layer 8 in the fourth or fifth exemplary embodiment. A part of the silicon compound film is removed by the first etching, and the adiabatic trench 7 is formed. At this time, in the first to third exemplary embodiments or the fifth exemplary embodiment, only the silicon compound film is removed. However, in the fourth exemplary embodiment, in addition to the silicon compound film, the sacrifice layer is also removed.

In this way, the silicon compound film is converted into the on-substrate structure 3. However, it is important that the width of the shape is continuously changed, This shape must be naturally designed before the first etching is started. Moreover, in the second to fifth exemplary embodiments, the on-substrate structure 3 is designed to include a portion of the core 1 along the line drawn such that the on-substrate structure 3 operates as the optical waveguide.

After that, the second etching is carried out for fabricating the on-substrate structure 3 with the bridge structure. At this time, a portion corresponding to the narrow width portion of the on-substrate structure 3, namely, the silicon substrate 2 in the first to third exemplary embodiments, or the sacrifice layer 8 in the fourth or fifth exemplary embodiment is removed earlier. When the space is generated between the on-substrate structure 3 and the silicon substrate 2 by the second etching, it serves as the removed section 6 for separating both of them.

Here, when the removed section 6 is remarked in association with the advancement of the second etching, the removed section 6 of the on-substrate structure 3 is gradually grown from the narrower , portion to the wider portion. That is, the length of the removed section 6 along the longitudinal direction of the on-substrate structure 3 is gradually grown. Since the on-substrate structure 3 is gradually separated from the silicon substrate 2 so that the bridge structure is generated, the bridge structure is difficult to be damaged when it is formed.

It should be noted that since the timing when the second etching is completed is adjusted, the silicon substrate 2 can intentionally remain in the portion in which the width of the on-substrate structure 3 is wide in the first to third exemplary embodiments, and the sacrifice layer 8 can intentionally remain in the portion in which.the width of the on-substrate structure 3 is wide in the fourth or fifth exemplary embodiment. The remainder serves as the supporting column 5 for supporting the on-substrate structure 3.

While the present invention has been particularly shown and described with reference to the exemplary embodiments thereof, the present invention is not limited to these exemplary embodiments. It will be understood by those of ordinary skill in the art that various changes in form and details may be made therein without departing, from the scope of the present invention as defined by the claims.

## Claims

1. A method of manufacturing a silicon structure, comprising:
forming an on-substrate structure on a processed layer to have a continuously changing width on a parallel plane to said processed layer; and
gradually removing a target portion of said processed layer on a silicon substrate, which is located directly beneath said on-substrate structure, by isotropic etching.

2. The method according to claim 1, wherein said processed layer is a surface layer of said silicon substrate.

3. The method according to claim 1, wherein said processed layer is a sacrifice layer formed on said silicon substrate.

4. The method according to any of claims 1 to 3, wherein said forming an on-substrate structure comprises:
forming a silicon compound film on said processed layer; and
removing a part of said processed film by an etching to form said on-substrate structure on said processed layer such that said on-substrate structure has a designed shape.

5. The method according to claim 4, wherein said gradually removing a target portion comprises:
starting said isotropic etching to said processed layer while leaving said silicon oxide film;
removing the target portion corresponding to a narrow portion of said on-substrate structure in width by said isotropic etching; and
ending said isotropic etching at a predetermined timing.

6. The method according to claim 5, wherein said gradually removing further comprises:
forming supporting columns from said target portion.

7. The method according to any of claims 4 to 6, wherein said forming a silicon compound film comprises:
forming a silicon oxide film as a lower clad layer on said silicon substrate;
forming a silicon oxide film with a refractive index different from that of said lower clad layer as a core; and
forming a silicon oxide film as an upper clad layer to put said core between said lower and upper clad layers,
wherein an optical waveguide is formed from said core and said lower and upper clad layers.

8. The method according to claim 7, further comprising:
forming a metal heater on said upper clad, wherein said optical waveguide and said metal heater functions as a thermo-optic phase shifter.

9. The method according to claim 4, wherein said silicon compound film is one of a silicon oxide film, a silicon carbide film, and a silicon nitride film.

10. A silicon structure comprising:
a processed layer as a part of a silicon substrate or formed on said silicon substrate; and
an on-substrate structure formed on said processed layer,
wherein said on-substrate structure comprises a silicon compound film,
said on-substrate structure comprises supporting columns configured to support a target portion of said processed layer directly beneath said on-substrate structure, and
said on-substrate structure has a portion that a width continuously changes.

11. The silicon structure according to claim 10, wherein said on-substrate structure has a portion formed along a line which belongs to a parallel plane to a surface of said processed layer.

12. The silicon structure according to claim 10, wherein said silicon compound film comprises one of a silicon oxide film, a silicon carbide film, and a silicon nitride film.

13. The silicon structure according to claim 10, wherein said on-substrate structure comprises:
a clad layer formed of silicon oxide; and
a core formed of a silicon oxide film with impurity doped and having a refractive index different from that of said clad layer.

14. A therneo-optic phase shifter comprising:
said silicon structure according to any of claims 10 to 13; and
a film heater formed of metal on said on-substrate structure.
